# EUROPEAN PATENT APPLICATION

(11) **EP 2 854 491 A1**
(43) Date of publication of application: **01.04.2015**
(21) Application number: 14160440.5
(22) Date of filing: 18.03.2014
(51) Int. Cl.: H05K 3/24

(54) **Light emitting module and lighting device**

(30) Priority: 25.09.2013 JP 2013198901
(71) Applicant: Toshiba Lighting & Technology Corporation, Yokosuka-shi Kanagawa 237-8510 (JP)
(72) Inventor: Honma, Takuya, Kanagawa 237-8510 (JP); Shibusawa, Yumiko, Kanagawa 237-8510 (JP)
(74) Representative: Bokinge, Ole

(57) **Abstract**

According to one embodiment, there is provided a light emitting module (15) including a board (21), a semiconductor light emitting element (45), an electronic component (57), a first pad (28), and a second pad (58). The surface of the first pad (28) on the board (21) is covered with a metal film. The semiconductor light emitting element (45) is mounted on the first pad (28). The surface of the second pad (58) is covered with a metal film. The electric component (57) is mounted on the second pad (58). The semiconductor light emitting element (45) is wire-bonded on the first pad (28) covered with the metal film. The electric component (57) is joined by solder on the second pad (58) covered with the metal film. The metal film covering the first pad (28) has a film structure lower in density than the metal film covering the second pad (58).

## Description

### FIELD

Embodiments described herein relate to a light emitting module and a lighting device.

### BACKGROUND

LED (Light Emitting Diode) lighting is introduced into facilities and general households at an accelerating pace as an environmentally friendly light source from the viewpoints of long life, power saving, and the like. Currently, a chip on board (COB) type in which plurality of LED chips are mounted on a board to increase brightness is a mainstream. As the board, in terms of productivity and the like, an organic board of resin or the like formed by applying silver plating to a reflecting layer and a mounting pad is often used.

Plating requires extremely advanced know-how and is high in costs. Residues due to stain or the like of plating liquid sometimes adhere to the surface of a plated metal film. When the residues adhere to the surface of the reflecting layer, the reflectance of light of the reflecting layer deteriorates. Therefore, when a lighting device is configured using such a board, light emitting efficiency of lighting as a whole is sometimes deteriorated.

In recent years, a technique for forming a metal film through printing is also developed. However, the metal film formed by the printing has low density. Therefore, when a component is joined on the metal film by solder, the solder erodes the metal film and the component tends to peel together with the metal film.

### BRIEF DESCRIPTION OF THE DRAWINGS

FIG. 1 is a perspective view showing an example of a lighting device according to a first embodiment;
FIG. 2 is a sectional view showing the example of the lighting device according to the first embodiment;
FIG. 3 is a conceptual diagram showing an example of an electrical connection relation of the lighting device according to the first embodiment;
FIG. 4 is a diagram showing an example of the configuration of a light emitting module according to the first embodiment;
FIG. 5 is a diagram showing an example of mounting pads provided on a board according to the first embodiment;
FIG. 6 is a top view showing an example of a light emitting unit according to the first embodiment;
FIG. 7 is an A-A sectional view of the light emitting unit shown in FIG. 6;
FIG. 8 is a conceptual diagram for explaining an electric component mounted on the mounting pads;
FIG. 9 is a top view showing an example of a light emitting unit according to a second embodiment; and
FIG. 10 is a B-B sectional view of the light emitting unit shown in FIG. 9.

### DETAILED DESCRIPTION

It is an object of the present invention to prevent deterioration in light emitting efficiency and prevent peeling of a component.

According to one embodiment, there is provided a light emitting module including: a board; an LED, which is an example of a semiconductor light emitting element; an electronic component; a first pad provided on the board, the surface of the first pad being covered with a metal film and the LED being mounted on the first pad; and a second pad provided on the board, the surface of the second pad being covered with a metal film and the electric component being mounted on the second pad. The LED is wire-bonded on the first pad covered with the metal film. The electric component is joined by solder on the second pad covered with the metal film. The metal film covering the first pad has a film structure lower in density than the metal film covering the second pad. With the light emitting module having such a configuration, it can be expected to prevent deterioration in light emitting efficiency and prevent peeling of a component.

In the light emitting module according to the embodiment, the metal film covering the first pad may be formed on the surface of the first pad by printing. The metal film covering the second pad may be formed on the surface of the second pad by plating. Consequently, it can be expected to prevent deterioration in light emitting efficiency and prevent peeling of a component at low costs.

In the light emitting module according to the embodiment, the metal film covering the first pad may be formed of gold or silver on the surface of the first pad. The metal film covering the second pad may be formed of gold, silver, or rhodium on the surface of the second pad.

In the light emitting module according to the embodiment, the board may be formed of ceramic. Consequently, it can be expected to improve light emitting efficiency of the light emitting module at low costs.

According to another embodiment, there is provided a lighting device including: the light emitting module; and a lighting-on device configured to supply electric power to the light emitting module.

A light emitting module and a lighting device according to embodiments are explained below with reference to the drawings. In the embodiments, components having the same functions are denoted by the same reference numerals and signs and redundant explanation of the components is omitted. The light emitting module and the lighting device explained in the embodiments are only an example and do not limit the present invention. The embodiments may be combined as appropriate to the extent that the embodiments do not contradict each other.

### First Embodiment

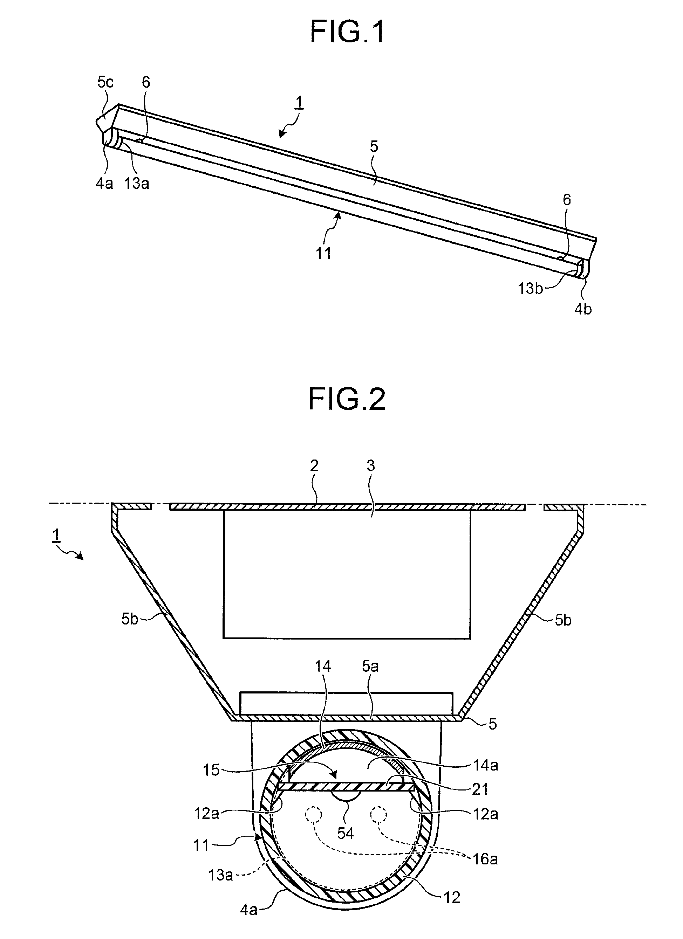

A straight tube type lamp and a lighting device including the straight tube type lamp, for example, a lighting apparatus according to a first embodiment are explained below with reference to FIGS. 1 to 4.

### Configuration of a lighting device 1

FIG. 1 is a perspective view illustrating an example of the lighting device according to the first embodiment. FIG. 2 is a cross-sectional view of the lighting apparatus illustrated in FIG. 1. In FIGS. 1 and 2, a numeral 1 illustrates a direct-mounted type lighting device.

The lighting device 1 includes a device body (an apparatus body) 2, a lighting-on device 3, a pair of first socket 4a and second socket 4b, a reflection member 5, a straight tube type lamp 11 that is an example of a light source device, and the like.

The body 2 illustrated in FIG. 2 is, for example, made of a metal plate having an elongated shape. The body 2 extends in a front and back direction of a paper on which FIG. 2 is drawn. The body 2 is, for example, fixed to a ceiling in a room by using a plurality of screws (not illustrated).

The lighting-on device 3 is fixed to a middle section of the body 2 in a longitudinal direction. The lighting-on device 3 generates a DC output by receiving a commercial AC power supply and supplies the DC output to the straight tube type lamp 11 described below.

Moreover, the body 2 has a power supply terminal stand (not illustrated), a plurality of member support fittings, a pair of socket support members, and the like. A power supply line of the commercial AC power supply drawn from a ceiling is connected to the power supply terminal stand. Further, the power supply terminal stand is electrically connected to the lighting-on device 3 through a wiring (not illustrated) in the apparatus.

The socket 4a and the socket 4b are disposed in both end sections of the body 2 in the longitudinal direction by being respectively connected to the socket support members. The socket 4a and the socket 4b are mounted by rotation. For example, the socket 4a and the socket 4b are sockets suitable for G13 type mouthpieces 13a and 13b, respectively, which are included in the straight tube type lamp 11 described below.

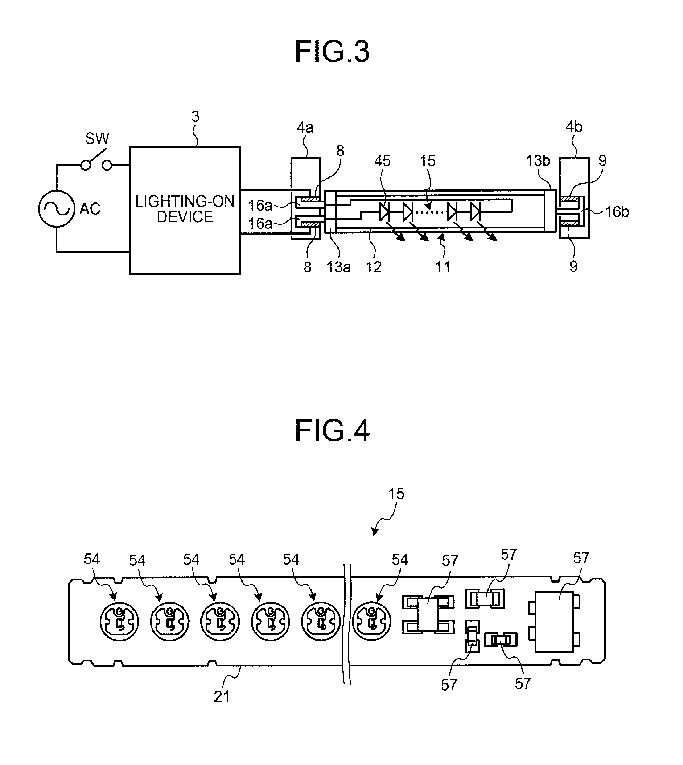

FIG. 3 is a conceptual view illustrating an example of an electrical connection relationship of the lighting device according to the first embodiment. As illustrated in FIG. 3, the socket 4a and the socket 4b have a pair of terminal fittings 8 and terminal fittings 9 to which lamp pins 16a and 16b (described below) are respectively connected. In order to supply the power supply to the straight tube type lamp 11 described below, the terminal fittings 8 of the first socket 4a are connected to the lighting-on device 3 through the wiring in the apparatus.

As illustrated in FIG. 1 or 2, for example, the reflection member 5 has a bottom plate section 5a, a side plate section 5b and an end plate 5c, which are made of metal and has a trough shape of which an upper surface is opened. The bottom plate section 5a is flat. The side plate section 5b is bent obliquely upward from the both ends of the bottom plate section 5a in a width direction. The end plate 5c closes an end surface opening formed by ends of the bottom plate section 5a and the side plate section 5b in the longitudinal direction.

A metal plate forming the bottom plate section 5a and the side plate section 5b is made of a color steel plate of which a surface has a white-based color. Thus, the surfaces of the bottom plate section 5a and the side plate section 5b are reflection surfaces. Socket holes (not illustrated) are formed on respective ends of the bottom plate section 5a in the longitudinal direction.

The reflection member 5 covers the body 2 and each component that is mounted on the body 2. The state is held by detachable decorative screws 6 (see FIG. 1). The decorative screw 6 is screwed upwardly into the member support fitting through the bottom plate section 5a. The decorative screw 6 may be operated by hand without using any tool. The socket 4a and the socket 4b protrude downward from the bottom plate section 5a through the socket holes.

In FIG. 1, the lighting device 1 supports one straight tube type lamp 11 described below, but, for example, may include two pairs of sockets to support two straight tube type lamps 11 as another form.

The straight tube type lamp 11 that is detachably supported by the socket 4a and the socket 4b is described below with reference to FIGS. 2 and 3. The straight tube type lamp 11 has dimensions and an outer diameter similar to those of the existing fluorescent lamp. The straight tube type lamp 11 includes a pipe 12, a first mouthpiece 13a and a second mouthpiece 13b which are mounted in both ends of the pipe 12, a beam 14 and a light emitting module 15.

The pipe 12 is formed of a resin material having translucency, for example, in an elongated shape. As the resin material forming the pipe 12, a polycarbonate resin in which a light diffusion member is mixed can be preferably used. Diffuse transmittance of the pipe 12 is preferably 90% to 95%. As illustrated in FIG. 2, the pipe 12 has a pair of convex sections 12a on an inner surface of a portion that is an upper section when being used.

The first mouthpiece 13a is mounted on one end section of the pipe 12 in the longitudinal direction and the second mouthpiece 13b is mounted on the other end section of the pipe 12 in the longitudinal direction. The first mouthpiece 13a and second mouthpiece 13b are detachably connected to the socket 4a and the socket 4b, respectively. The straight tube type lamp 11 that is supported on the socket 4a and the socket 4b is disposed directly below the bottom plate section 5a of the reflection member 5 by the connection. A part of light that is emitted from the straight tube type lamp 11 to the outside is reflected from the side plate section 5b of the reflection member 5.

As illustrated in FIG. 3, the first mouthpiece 13a has two lamp pins 16a protruding to the outside thereof. The lamp pins 16a are electrically insulated from each other. In addition, leading ends of the two lamp pins 16a have L-shapes which are bent substantially at a right angle so as to separate from each other.

As illustrated in FIG. 3, the second mouthpiece 13b has one lamp pin 16b protruding to the outside thereof. The lamp pin 16b has a cylindrical shaft section and a leading end section which is provided in a leading end section of the cylindrical shaft section, and of which a shape of a front surface (not illustrated) has an elliptical shape or an oval shape, and a side surface of the lamp pin 16b has a T-shape.

The lamp pins 16a of the first mouthpiece 13a are connected to the terminal fittings 8 of the socket 4a and the lamp pin 16b of the second mouthpiece 13b is connected to the terminal fittings 9 of the socket 4b so that the straight tube type lamp 11 is mechanically supported on the socket 4a and the socket 4b. In a state of being supported, power is supplied to the straight tube type lamp 11 by the terminal fittings 8 inside the socket 4a and the lamp pins 16a of the first mouthpiece 13a connected thereto.

As illustrated in FIG. 2, the beam 14 is accommodated in the pipe 12. The beam 14 is a bar member having excellent mechanical strength and, for example, is formed of an aluminum alloy or the like for weight reduction. Both ends of the beam 14 in the longitudinal direction are connected to the first mouthpiece 13a and the second mouthpiece 13b by being electrically insulated. For example, the beam 14 has a plurality of substrate support sections 14a (one is illustrated in FIG. 2) having rib shapes.

FIG. 4 is a diagram showing an example of the configuration of the light emitting module according to the first embodiment. As shown in FIG. 4, in the light emitting module 15, on a board 21 formed in an elongated substantially rectangular tabular shape, a plurality of light emitting units 54 are arranged side by side in a longitudinal direction of the board 21.

Various electric components 57 such as resistors and connectors are arranged on the board 21. Not to prevent lights emitted by the light emitting units 54, the electric components 57 are arranged close to a corner on the board 21 or on the rear surface of the surface of the board 21 on which the light emitting units 54 are provided.

In this embodiment, the board 21 is, for example, a glass epoxy board formed using resin. The front surface of the board 21 is covered with a resist layer containing synthetic resin having high electric insulation properties except a surface on which mounting pads mounted with the light emitting units 54 and the electric components 57 are provided. The resist layer is, for example, white and also functions as a reflecting layer having high light transmittance.

The length of the board 21 is substantially equal to the total length of the beam 14. The board 21 is fixed by not-shown screws screwed into the beam 14. In this embodiment, the light emitting module 15 includes one board 21. However, as another form, the light emitting module 15 may include a plurality of the boards 21.

The light emitting module 15 is housed in the pipe 12 together with the beam 14. In this supported state, both ends in the width direction of the light emitting module 15 are placed on the convex sections 12a of the pipe 12. Consequently, the light emitting module 15 is disposed substantially horizontally further on the upper side than a maximum width section in the pipe 12.

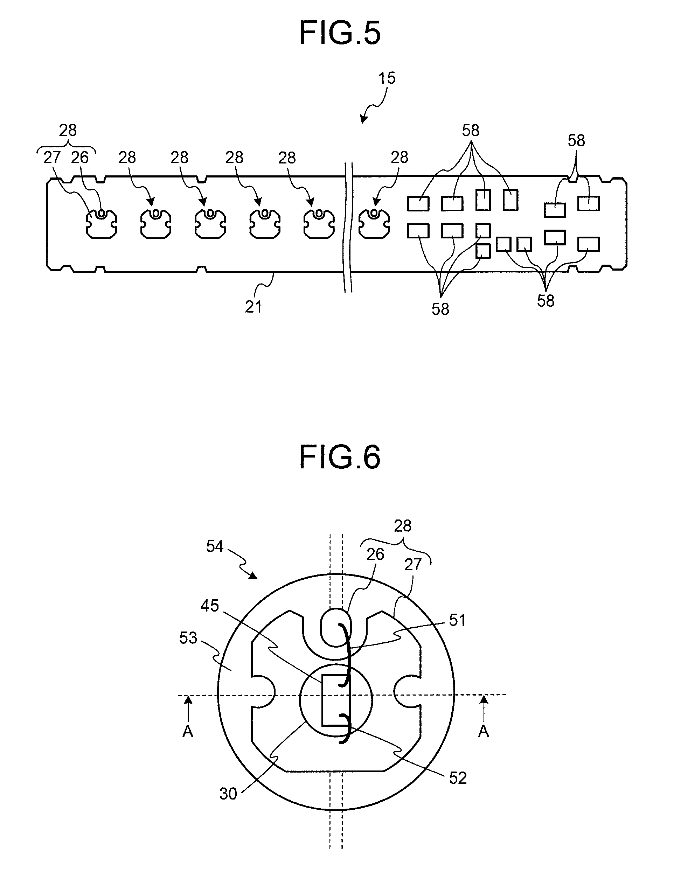

FIG. 5 is a diagram showing an example of mounting pads provided on the board according to the first embodiment. On the board 21, a plurality of mounting pads 28 on which the light emitting units 54 are mounted and a plurality of mounting pads 58 on which the electric components 57 are mounted are provided. Each of the mounting pads 28 includes a wiring pad 26 and a wiring pad 27.

In this embodiment, the surfaces of the wiring pad 26 and the wiring pad 27 are covered with a metal film having a low density film structure. In this embodiment, the metal film covering the surfaces of the wiring pad 26 and the wiring pad 27 is formed of a material having high reflectance, for example, gold. As another form, the metal film may be formed of silver or the like. In this embodiment, the metal film is formed on the surfaces of the wiring pad 26 and the wiring pad 27 by printing.

In this embodiment, the surface of each of the mounting pads 58 is covered with a metal film having a film structure higher in density than the metal film covering the wiring pad 26 and the wiring pad 27. In this embodiment, the metal film covering the surface of the mounting pad 58 is formed of, for example, silver. As another form, the metal film may be formed of gold, rhodium, or the like. In this embodiment, the metal film is formed on the surface of the mounting pad 58 by plating.

### Configuration of the light emitting unit 54

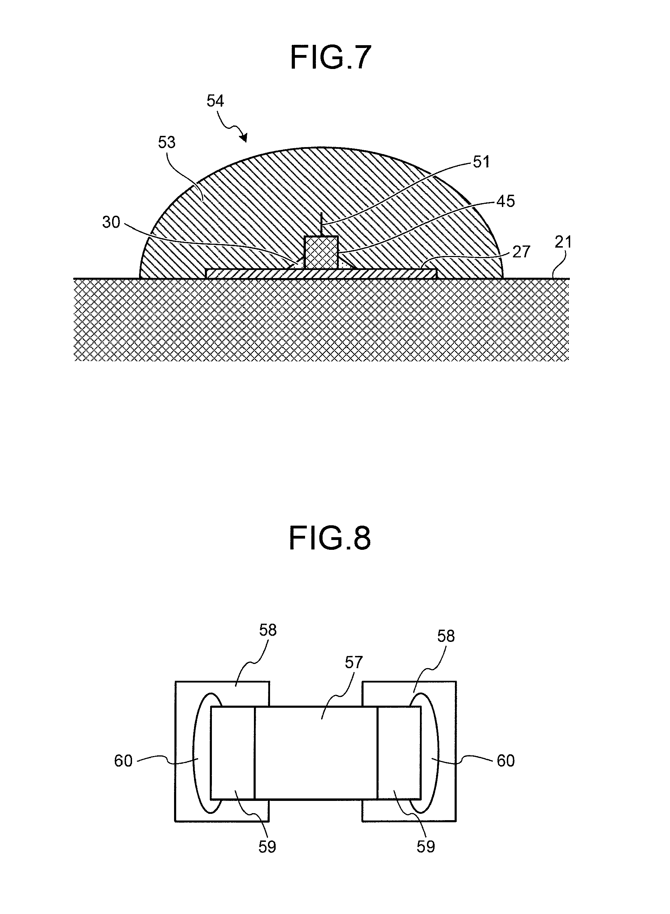

FIG. 6 is a top view showing an example of the light emitting unit according to the first embodiment. FIG. 7 is an A-A sectional view of the light emitting unit shown in FIG. 6.

The light emitting unit 54 includes an LED 45 and a sealing member 53. The LED 45 includes a base material formed of sapphire or the like and a semiconductor layer (a light emitting layer) including gallium nitride (GaN) formed on the base material. The base material is die-bonded on the wiring pad 27 by, for example, a white or silver adhesive 30 having high reflectance.

On the light emitting layer, an anode electrode and a cathode electrode are formed. The anode electrode of the light emitting layer is wire-bonded to the wiring pad 26 by a wire 51 of gold or the like. The cathode electrode of the light emitting layer is wire-bonded to the wiring pad 27 by a metal wire 52 of gold or the like. The wiring pad 26 and the wiring pad 27 are connected to the wiring layer provided on the board 21.

The sealing member 53 is thermosetting transparent resin having high diffusibility such as epoxy resin, urea resin, or silicon resin added with a phosphor. The phosphor is excited by light emitted by the LED 45 to emit light having a color different from a color of the light emitted by the LED 45.

In this embodiment, as the phosphor, a yellow phosphor is used that is excited by blue light emitted by the LED 45 to emit yellow-based light, which is in a complementary color relation with the blue light. Consequently, the light emitting unit 54 can emit white light as output light.

FIG. 8 is a conceptual diagram for explaining an electric component mounted on the mounting pads. In the electric component 57 such as a resistor or a connector, for example, as shown in FIG. 8, terminals 59 of the electric component 57 are joined to the mounting pad 58 by solder 60.

If the metal film on the surfaces of the mounting pads is formed by plating, residues sometimes remain on the surface of the metal film in a process in which plating liquid dries. When the residues are present on the surface of the metal film, the reflectance of the metal film deteriorates. Therefore, if the metal film is present near the LED 45, light emitted from the LED 45 is absorbed by the metal film. The light emitting efficiency of the entire light emitting module 15 is sometimes deteriorated

If the residues are present on the surface of the metal film, when a metal wire is wire-bonded on the metal film, heat of a capillary is not sufficiently transmitted to the metal film and the mounting pads under the residues. The distal end of the metal wire and the mounting pads are not sometimes joined at sufficient strength. Since an advanced technique and equipment are necessary for the plating, costs are relatively high.

On the other hand, in the printing, since it is possible to form a metal film with less stain, it is possible to form a metal film having high reflectance. In the metal film formed by the printing, less dust such as residues remains on the surface. Therefore, when the metal wire is bonded on the metal film, the distal end of the metal wire and the mounting pads can be joined at sufficient strength. The printing can be realized at low costs compared with the plating.

However, if the metal film covering the surfaces of the mounting pads is formed by the printing, when a component is joined on the metal film by solder, the solder erodes the metal film. If the solder erodes the metal film, the component tends to peel together with the metal film.

This is because the metal film formed by the printing has a film structure lower in density than the metal film formed by the plating. A difference in the density of the film structure can be determined by, for example, photographing the cross section of the metal film with a scanning electron microscope (SEM) and comparing the number and the size of air gaps in a photographed image. In an SEM image of the cross section of the metal film formed by the printing, the number of air gaps is apparently large and the size of the air gaps is large compared with an SEM image of the cross section of the metal film formed by the plating.

Therefore, in this embodiment, the surfaces of the mounting pads, on which a component joined by solder is mounted, are covered with a metal film having a high density film structure. The surfaces of the mounting pads required to have high reflectance and the mounting pads bonded by a metal wire are covered with a metal film having a low density film structure. The metal film having the high density film structure is formed by, for example, plating and the metal film having the low density film structure is formed by, for example, printing.

Consequently, on the mounting pads 58 mounted using solder, the metal film is formed by the plating as in the past. Therefore, it can be expected to prevent peeling of the electric component 57. On the mounting pad 28 around the LED 45, the metal film is formed by the printing. Therefore, it is possible to improve the light emitting efficiency of the light emitting module 15 and it can be expected to reduce manufacturing costs for the light emitting module 15.

The first embodiment is explained above.

As it is evident from the above explanation, with the light emitting module 15 in this embodiment, it is possible to improve the light emitting efficiency of the light emitting module 15 and it can be expected to prevent peeling of a component.

### Second Embodiment

A second embodiment is explained with reference to the drawings. The configurations of the lighting device 1, the straight tube type lamp 11, and the light emitting module 15 in this embodiment are the same as the configurations of the lighting device 1, the straight tube type lamp 11, and the light emitting module 15 in the first embodiment. Therefore, detailed explanation of the configurations is omitted.

### Configuration of the light emitting unit 54

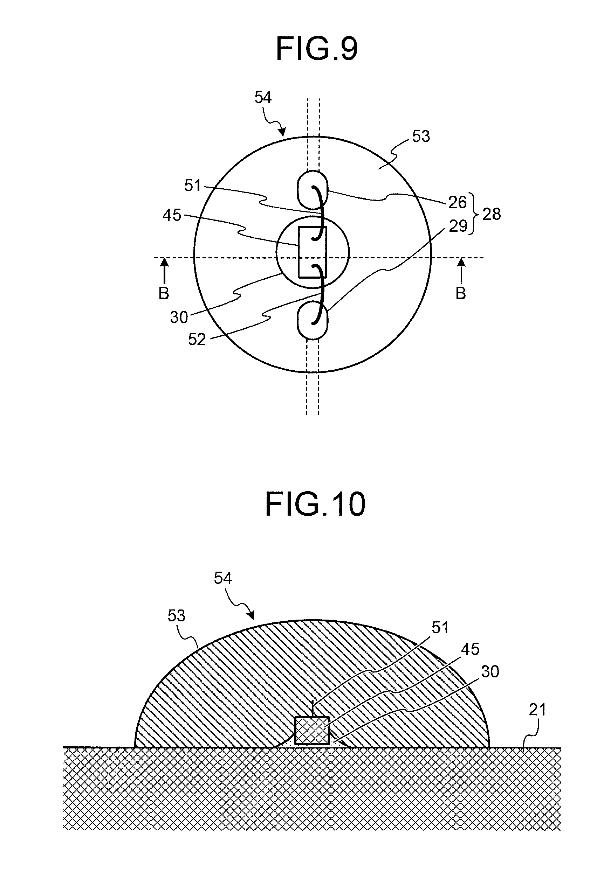

FIG. 9 is a top view showing an example of a light emitting unit according to the second embodiment. FIG. 10 is a B-B sectional view of the light emitting unit shown in FIG. 9. Except points explained below, in FIG. 9 or 10, components denoted by reference numerals same as the reference numerals in FIG. 6 or 7 have functions same as or similar to the functions of the components shown in FIG. 6 or 7. Therefore, explanation of the components is omitted.

In this embodiment, the board 21 is formed of a material having insulation properties and high reflectance, for example, ceramic. In this embodiment, each of the mounting pads 28 includes the wiring pad 26 and a wiring pad 29. The surface of the wiring pad 29 is covered with a metal film having a low density film structure.

In this embodiment, the metal film covering the surface of the wiring pad 29 is formed of a material having high reflectance, for example, gold. As another form, the metal film may be formed of silver or the like. In this embodiment, the metal film is formed on the surface of the wiring pad 29 by printing.

In this embodiment, a base material of the LED 45 is die-bonded on the board 21 by, for example, the white or silver adhesive 30 having high reflectance. An anode electrode of a light emitting layer is wire-bonded to the wiring pad 26 by the wire 51 of gold or the like. A cathode electrode of the light emitting layer is wire-bonded to the wiring pad 29 by the metal wire 52 of gold or the like. The wiring pad 26 and the wiring pad 29 are connected to a wiring layer provided on the board 21.

As the board 21 in this embodiment, ceramic having relatively high reflectance is used. Therefore, it is unnecessary to form a metal film having high reflectance on the surface of the board 21 on which the LED 45 is bonded. Therefore, it is possible to reduce a region where a metal film having high reflectance of gold or the like is formed. It can be expected to suppress costs of the light emitting module 15.

In this embodiment, as in the first embodiment, the metal film of gold or the like is formed on the surfaces of the wiring pad 26 and the wiring pad 29 by printing. A metal film of silver or the like is formed by plating on the surface of a mounting pad on which an electric component is joined by solder.

The second embodiment is explained above.

As it is evident from the above explanation, in the light emitting module 15 in this embodiment, as in the first embodiment, it is possible to improve the light emitting efficiency of the light emitting module 15 and it can be expected to prevent peeling of a component.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting module comprising:
a board;
a semiconductor light emitting element;
an electronic component;
a first pad provided on the board, a surface of the first pad being covered with a metal film and the semiconductor light emitting element being mounted on the first pad; and
a second pad provided on the board, a surface of the second pad being covered with a metal film and the electric component being mounted on the second pad, wherein
the semiconductor light emitting element is wire-bonded on the first pad covered with the metal film,
the electric component is joined by solder on the second pad covered with the metal film, and
the metal film covering the first pad has a film structure lower in density than the metal film covering the second pad.

2. The module according to claim 1, wherein
the metal film covering the first pad is formed on the surface of the first pad by printing, and
the metal film covering the second pad is formed on the surface of the second pad by plating.

3. The module according to claim 1 or 2, wherein
the metal film covering the first pad is formed of gold or silver on the surface of the first pad, and
the metal film covering the second pad is formed of gold, silver, or rhodium on the surface of the second pad.

4. The module according to any one of claims 1 to 3, wherein the semiconductor light emitting element is die-bonded to the first pad by an adhesive.

5. The module according to any one of claims 1 to 3, wherein the board is formed of ceramic.

6. The module according to claim 5, wherein the semiconductor light emitting element is die-bonded on the board by an adhesive.

7. The module according to claim 4 or 6, wherein the adhesive is white or silver.

8. A lighting device comprising:
the light emitting module according to any one of claims 1 to 7; and
a lighting-on device configured to supply electric power to the light emitting module.
